# EUROPÄISCHE PATENTANMELDUNG

(11) **EP 3 301 717 A1**
(43) Veröffentlichungstag der Anmeldung: **04.04.2018**
(21) Anmeldenummer: 16191449.4
(22) Anmeldetag: 29.09.2016
(51) Int. Cl.: H01L 25/07, H01L 25/11, H01L 25/065

(54) **LEISTUNGSMODUL UND VORRICHTUNG**

(71) Anmelder: Siemens Aktiengesellschaft, 80333 München (DE)
(72) Erfinder: Kopf, Michael, 90537 Feucht (DE); Kriegel, Kai, 81739 München (DE); Mitic, Gerhard, 81827 München (DE); Raab, Oliver, 80337 München (DE); Weidner, Karl, 81245 München (DE)

(57) **Zusammenfassung**

Das Leistungsmodul umfasst zumindest ein erstes und ein zweites jeweils mit einem Flachteil gebildetes Halbleiterbauelement, bei welchem das Flachteil des zweiten Halbleiterbauelement in einer Richtung schräg, insbesondere quer, zu flächigen Erstreckungsrichtungen des Flachteils des ersten Halbleiterbauelements von diesem angeordnet und mittels eines elektrisch leitfähigen Leiterbahnflachteils elektrisch angebunden ist.

Die Vorrichtung ist insbesondere ein Umrichter und/oder eine Stromversorgungsvorrichtung und mit einem solchen Leistungsmodul gebildet.

## Beschreibung

Die Erfindung betrifft ein Leistungsmodul und eine Vorrichtung.

Bei herkömmlichen Leistungsmodulen gibt es in vielerlei Hinsicht Verbesserungsbedarf: Zum einen ist die Trägerkeramik des Substrats verhältnismäßig teuer. Zum anderen lassen sich häufig Materialeigenschaften von Halbleitermaterialien, die bei Leistungsmodulen eingesetzt werden, nicht vollständig ausnutzen. Insbesondere ist bei Wide-Bandgap-Halbleitern, etwa SiC oder GaN, das Schaltverhalten begrenzt. Zudem wäre eine verbesserte Abfuhr von Verlustleistung wünschenswert.

Vor diesem Hintergrund des Standes der Technik ist es Aufgabe der Erfindung, ein verbessertes Leistungsmodul anzugeben. Insbesondere soll das Leistungsmodul kostengünstig sein, ein verbessertes Schaltverhalten aufweisen und eine verbesserte Abfuhr von Verlustleistung erlauben. Ferner ist es Aufgabe der Erfindung, eine verbesserte Vorrichtung mit einem Leistungsmodul bereitzustellen.

Diese Aufgabe der Erfindung wird mit einem Leistungsmodul mit den in Anspruch 1 angegebenen Merkmalen sowie mit einer Vorrichtung mit den in Anspruch 10 angegebenen Merkmalen gelöst. Bevorzugte Weiterbildungen der Erfindung sind in den zugehörigen Unteransprüchen, der nachfolgenden Beschreibung und der Zeichnung angegeben.

Das erfindungsgemäße Leistungsmodul umfasst zumindest ein erstes und ein zweites, jeweils mit einem Flachteil gebildetes, Halbleiterbauelement, bei welchem das Flachteil des zweiten Halbleiterbauelements in einer Richtung schräg, insbesondere quer, zu flächigen Erstreckungsrichtungen des Flachteils des ersten Halbleiterbauelements von diesem angeordnet und mittels eines elektrisch leitfähigen Leiterbahnflachteils elektrisch angebunden ist.

Die erfindungsgemäß neuartige räumliche Anordnung der Halbleiterbauelemente des Leistungsmoduls ermöglicht gegenüber dem Stand der Technik deutliche Verbesserungen: Denn in bislang bekannten leistungselektronischen Modulen (im Rahmen dieser Anmeldung stets kurz als "Leistungsmodule" bezeichnet) sind die Halbleiterbauelemente alle auf einer Ebene nebeneinander angeordnet. Die hat zur Folge, dass zur Realisierung elektrischer Schaltkreise relativ große Substratflächen für die Anordnung der Halbleiterbauelemente sowie der elektrischen Leiterbahnen erforderlich sind. Die Kontaktierung der Chipoberseiten erfolgt in bekannten Lösungen regelmäßig durch Bonddrähte, die eine elektrische Verbindung zu einer Kupferleiterbahn auf einer DCB-Ebene herstellen. Diese Technologie verursacht sehr hohe parasitäre Kommutierungsinduktivitäten, die hohe Überspannungen bei den Schaltvorgängen verursachen. Diese können wiederum zur Zerstörung der Schalter führen, oder die Schalter müssen entsprechend überdimensioniert werden.

Bei dem erfindungsgemäßen Leistungsmodul hingegen ist das Flachteil des zweiten Halbleiterbauelements nicht entlang der flächigen Erstreckungsrichtungen des Flachteils des ersten Halbleiterbauelements verschoben angeordnet, sondern das zweite Halbleiterbauelement ist schräg, insbesondere quer, d.h. senkrecht, zu diesen flächigen Erstreckungsrichtungen versetzt angeordnet. Folglich ist in Richtung der flächigen Erstreckungsrichtung des Flachteils des ersten Halbleiterbauelements der Platzbedarf der zumindest zwei vorhandenen Halbleiterbauelemente reduziert.

Unter flächigen Erstreckungsrichtungen im Sinne dieser Anmeldung sind Richtungen zu verstehen, welche die Ebene einer Flachseite eines Flachteils des ersten Halbleiterbauelements aufspannen. Vorzugsweise ist die Flachseite des Flachteils eben. Im Falle einer unebenen Flachseite tritt an die Stelle der Ebene einer Flachseite eine Tangentialebene der Flachseite, d.h. jene Richtungen, die die Tangentialebene aufspannen, bilden die flächigen Erstreckungsrichtungen. Schräg zu flächigen Erstreckungsrichtungen im Sinne dieser Anmeldung meint schräg zu sämtlichen Erstreckungsrichtungen, also schräg zur von den Erstreckungsrichtungen aufgespannten Ebene. Quer zu flächigen Erstreckungsrichtungen meint folglich senkrecht zur von den Erstreckungsrichtungen aufgespannten Ebene.

Die erfindungsgemäße Lösung weist mittels der Leiterbahnflachteile ferner einen planaren Aufbau auf, welcher die Herstellung von Leistungsmodulen erlaubt, bei denen die Bonddrähte durch Leiterbahnflachteile ersetzt sind. Grundsätzlich kann das Vorsehen von Leiterbahnflachteilen mit bekannten Verfahren erfolgen, beispielsweise mit dem SiPLIT-Verfahren aus dem Hause Siemens oder mittels des Skim-Verfahrens. Mit diesen Verfahren kann die Kommutierungsinduktivität deutlich reduziert werden

Besonders bevorzugt bildet das Leistungsmodul ein einstückig handhabbares Bauteil.

In einer bevorzugten Weiterbildung des erfindungsgemäßen Leistungsmoduls erstrecken sich die flächigen Erstreckungsrichtungen des Flachteils des ersten Halbleiterbauelements und des Flachteils des zweiten Halbleiterbauelements in zueinander parallelen Ebenen oder zueinander parallelverschobenen Tangentialebenen. In dieser Weiterbildung der Erfindung ist die Anordnung von erstem und zweitem Halbleiterbauelement besonders platzsparend möglich. Folglich kann die erforderliche Substratfläche und damit die erforderliche Materialmenge an Keramik deutlich reduziert werden.

Das erfindungsgemäße Leistungsmodul ist nicht allein auf Leistungsmodule mit zwei Halbleiterbauelementen beschränkt. In einer bevorzugten Weiterbildung weist das erfindungsgemäße Leistungsmodul zusätzlich mindestens ein drittes oder weitere mit jeweils mindestens einem Flachteil gebildete Halbleiterbauelemente auf, wobei das Flachteil des dritten oder der weiteren Halbleiterbauelemente jeweils in einer Richtung schräg, insbesondere quer, zu den flächigen Erstreckungsrichtungen des Flachteils des ersten und/oder zweiten Halbleiterbauelements von diesem angeordnet und vorzugsweise mittels des elektrisch leitfähigen Leiterbahnflachteils oder eines oder mehrerer weiterer Leiterbahnflachteile elektrisch angebunden ist/sind.

Vorzugsweise überlappt bei dem erfindungsgemäßen Leistungsmodul das erste mit dem zweiten Halbleiterbauelement und/oder dritten Halbleiterbaulemeent und/oder weiteren Halbleiterbauelementen in einer Richtung schräg, insbesondere quer, zu dem flächigen Erstreckungen des ersten und/oder zweiten Halbleiterbauelements gesehen. Vorzugsweise überlappen die Flachteile des ersten und zweiten und/oder dritten Halbleiterbauelements und/oder weiterer Halbleiterbauelemente.

Bevorzugt ist bei dem erfindungsgemäßen Leistungsmodul das Leiterbahnflachteil mit Metall, insbesondere mit Kupfer gebildet. Auf diese Weise lassen sich etalierte Fertigungsverfahren zur Fertigung des erfindungsgemäßen Leistungsmoduls in an sich bekannter Weise nutzen.

In einer vorteilhaften Weiterbildung der Erfindung ist bei dem erfindungsgemäßen Leistungsmodul das Leiterbahnflachteil an erstes und/oder zweites Halbleiterbauelement, insbesondere jeweils an das Flachteil des ersten und/oder zweiten Halbleiterbauelements, gesintert. In dieser Weiterbildung der Erfindung sind Leiterbahnflachteil und Halbleiterbauelement miteinander in bekannter Weise stoffschlüssig verbunden, so dass ein dauerhaft fehlerfreier elektrischer Leitungskontakt gewährleistet ist. Sinterverbindungen widerstehen zuverlässig thermischer und mechanischer Beanspruchung. Die Robustheit und Ausfallsicherheit des erfindungsgemäßen Leistungsmoduls sind auf diese Weise erhöht.

Bei dem erfindungsgemäßen Leistungsmodul ist bevorzugt das erste und/oder zweite Halbleiterbauelement, insbesondere eine Flachseite des mindestens einen Flachteils dieses Halbleiterbauelements, an ein Substrat, insbesondere ein DCB-Substrat, angebunden *(DCB (eng.) = "Direct Copper Bonded").* Auf diese Weise können etablierte Fertigungsverfahren zur Herstellung des erfindungsgemäßen Leistungsmoduls eingesetzt werden. Ferner kann insbesondere mittels DCB-Substraten leicht eine effiziente Entwärmung realisiert werden.

Vorzugsweise nimmt bei dem erfindungsgemäßen Leistungsmodul das eine oder eines der Flachteile des ersten und/oder zweiten Halbleiterbauelements und/oder weiterer Halbleiterbauelemente mindestens die Hälfte, vorzugsweise zumindest 80 Prozent, weiter bevorzugt zumindest 90 Prozent und idealerweise 100 Prozent des Volumens, jeweils dieses Halbleiterbauelements ein. D.h., das erste und/oder zweite Halbleiterbauelement und/oder weitere Halbleiterbauelemente sind im Wesentlichen mit Flachteilen gebildet und vorzugsweise vollständig als Flachteile ausgebildet.

Bevorzugt weist das erfindungsgemäße Leistungsmodul mindestens einen Phasenanschluss auf, welcher an das mindestens eine Halbleiterbahnflachteil angebunden ist.

Die erfindungsgemäße Vorrichtung ist insbesondere ein Umrichter und/oder eine Stromversorgungsvorrichtung und weist ein erfindungsgemäßes Leistungsmodul, wie es oben beschrieben ist, auf.

Besonders bevorzugt ist das erfindungsgemäße Leistungsmodul ein Umrichter und/oder eine Stromversorgungseinrichtung.

Nachfolgend wird die Erfindung anhand eines in der Zeichnung dargestellten Ausführungsbeispiels näher erläutert.

Es zeigen:
- Figur 1: ein erfindungsgemäßes Leistungsmodul schematisch im Querschnitt sowie
- Figur 2: einen erfindungsgemäßen Umrichter schematisch in einer Prinzipskizze.

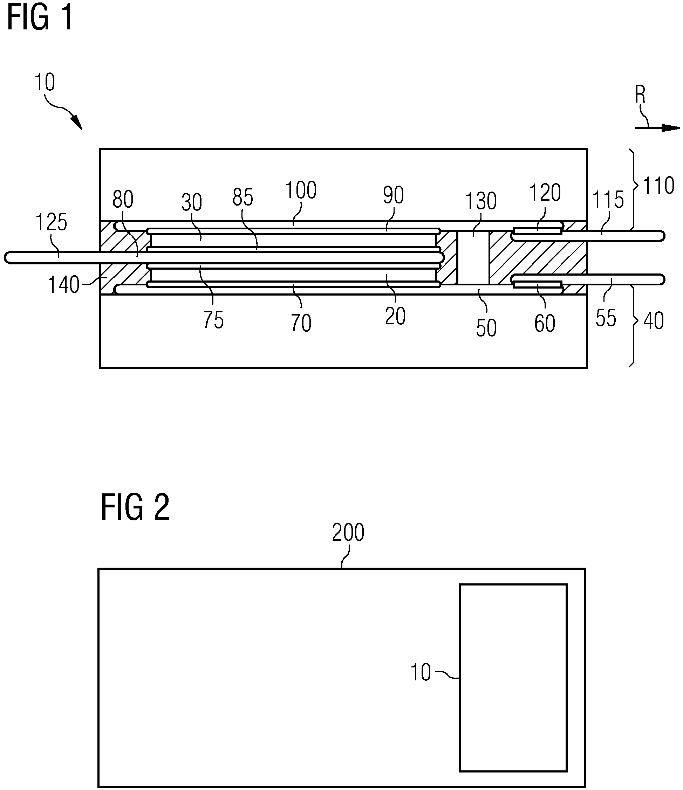

Das in Fig. 1 dargestellte Leistungsmodul 10 umfasst einen ersten 20 und einen zweiten Halbleiterchip 30.

Das Leistungsmodul 10 umfasst ferner einen Schaltungsträger in Gestalt eines mit kupferbeschichteter Keramik gefertigten DCB-Substrats 40 (DCB = (engl.) *"Direct Copper Bonder").* Das DCB-Substrat 40 umfasst in an sich bekannter Weise eine Kupferschicht 50, welche die Keramik flächig bedeckt. Auf die Kupferschicht 50 des DCB-Substrats 40 und fern der Keramik des DCB-Substrats 40 ist - in Richtung der flächigen Erstreckung der Kupferschicht 50 an einem Randbereich des Leistungsmoduls 10 - ein Low-Side-Schalter in der Art eines negativen Gleichspannungs-Leistungsanschlusses 55 flächig mittels einer Verbindungsschicht 60, im gezeigten einer Sinterschicht, elektrisch leitend angebunden, d.h. kontaktiert. Der Gleichspannungs-Leistungsanschluss 55 streckt sich in einer Richtung R vom übrigen Leistungsmodul 10 fort. Dabei bildet die Richtung R eine der flächigen Erstreckungsrichtungen der Kupferschicht 50.

Auf der Kupferschicht 50 des DCB-Substrats 40 ist flächig mittels einer weiteren Verbindungsschicht 70, im gezeigten Ausführungsbeispiel ebenfalls einer Sinterschicht, elektrisch leitend der erste Halbleiterchip 20 angebunden. Der Halbleiterchip 20 ist als Flachteil ausgebildet, wobei eine erste Flachseite des Halbleiterchips 20 mittels der Verbindungsschicht 70 an das DCB-Substrat 40 angebunden ist, während die zweite Flachseite des ersten Halbleiterchips 20 vom DCB-Substrat 40 abgewandt ist. An dieser vom DCB-Substrat 40 abgewandten Flachseite ist mittels einer weiteren als Sinterschicht ausgebildeten Verbindungsschicht 75 ein Kupferleiterrahmen 80 flächig und elektrisch leitend angebunden. Auch der Kupferleiterrahmen 80 ist als Flachteil ausgebildet und steht über eine erste Flachseite mittels der Verbindungsschicht 75 mit dem ersten Halbleiterchip 20 in Verbindung.

Der Kupferleiterrahmen 80 ist strukturiert ausgebildet, d.h. der Kupferleiterrahmen 80 bildet zwar ein Flachteil, ist aber zugleich nicht vollflächig ausgebildet, sondern mit einem Netz von Leiterbahnen gebildet, welche etwa den ersten Halbleiterchip 20 mit hinter der Zeichnungsebene sich an den ersten Halbleiterchip 20 in Richtung senkrecht zur Zeichenebene anschließenden (in der Zeichnung nicht explizit dargestellten) weiteren Halbleiterchips elektrisch verbinden.

Eine zweite, vom ersten Halbleiterchip abgewandte Flachseite des Kupferleiterrahmens 80 liegt flächig mittels einer weiteren als Sinterschicht ausgebildeten Verbindungsschicht 85 an dem zweiten Halbleiterchip 30, welcher als weiteres Flachteil mit seinen flächigen Erstreckungen parallel zu jenen des ersten Halbleiterchips 20 orientiert ist, elektrisch leitend und stoffschlüssig an.

Der zweite Halbleiterchip 30 ist mittels einer weiteren Verbindungsschicht 90, welche ebenfalls als Sinterschicht ausgebildet ist, an eine Kupferschicht 100 eines weiteren DCB-Substrats 110 flächig und elektrisch leitend angebunden. Die Anordnung des zweiten Halbleiterchips 30 an das weitere DCB-Substrat 110 bildet gewissermaßen ein Spiegelbild der Anordnung des ersten Halbleiterchips 20 an das DCB-Substrat 40, wobei eine zu den Flachseiten des Kupferleiterrahmens 80 parallele Längsmittelebene des Kupferleiterrahmens 80 eine Spiegelebene bildet.

Auf die Kupferschicht 100 des weiteren DCB-Substrats 110 und fern der Keramik des weiteren DCB-Substrats 110 ist - in Richtung der flächigen Erstreckung der Kupferschicht 100 an einem Randbereich des Leistungsmoduls 10 - ein High-Side-Schalter in der Art eines positiven Gleichspannungs-Leistungsanschlusses 115 flächig mittels einer Verbindungsschicht 120, im gezeigten einer Sinterschicht, elektrisch leitend angebunden, d.h. kontaktiert. Der Gleichspannungs-Leistungsanschluss 115 streckt sich ebenfalls in Richtung R vom übrigen Leistungsmodul 10 fort.

An einem entgegen Richtung R vom Gleichspannungs-Leistungsanschluss 115 entfernten Randbereich des Leistungsmoduls 10 weist der Leiterrahmen 80 einen Phasenanschluss 125 auf, welcher entgegen Richtung R vom übrigen Leistungsmodul 10 fort ausgezogen ist.

Aufgrund der flächigen Kontaktierung der beiden Halbleiterchips 20, 30 mittels der DCB-Substrate und des Kupferleiterrahmens 80 weist das Leistungsmodul 10 eine deutlich verringerte Kommutierungsschleife, also eine erheblich reduzierte Induktivität, auf. Zusätzlich ist zur weiteren Verringerung der Induktivität der externen Zuleitung ein Snubber-Kondensator 130 zwischen dem DCB-Substrat 40 und dem weiteren DCB-Substrat 110 vorhanden, welcher die Induktivität in an sich bekannter Weise reduziert.

Sowohl das DCB-Substrat 40 und das weitere DCB-Substrat 40 als auch der Kupferleiterrahmen 80 überragen den ersten 20 und den zweiten Halbleiterchip 30 in den flächigen Erstreckungen des ersten 20 und des zweiten Halbleiterchips 30. Der dort befindliche Freiraum ist optional mit einem Isolationsmaterial 140 vergossen.

Die erfindungsgemäße Vorrichtung 200 ist ein Umrichter und weist das erfindungsgemäße Leistungsmodul 10 wie vorhergehend beschrieben auf. In einem weiteren nicht gesondert dargestellten Ausführungsbeispiel ist die Vorrichtung 200 eine Stromversorgungsvorrichtung mit einem erfindungsgemäßen Leistungsmodul 10.

## Patentansprüche

1. Leistungsmodul, umfassend zumindest ein erstes (20) und ein zweites jeweils mit einem Flachteil gebildetes Halbleiterbauelement (30), bei welchem das Flachteil des zweiten Halbleiterbauelement (30) in einer Richtung schräg, insbesondere quer, zur Ebene der flächigen Erstreckungsrichtungen des Flachteils des ersten Halbleiterbauelements (20) von diesem angeordnet und mittels eines elektrisch leitfähigen Leiterbahnflachteils (80) elektrisch angebunden ist.

2. Leistungsmodul nach einem der vorhergehenden Ansprüche, bei welchem sich flächige Erstreckungsrichtungen des Flachteils des ersten Halbleiterbauelements (0) und des Flachteils des zweiten Halbleiterbauelements (30) in zueinander parallelen Ebenen oder zueinander parallelverschobenen Tangentialebenen erstrecken.

3. Leistungsmodul nach einem der vorhergehenden Ansprüche, welches zusätzlich mindestens ein drittes oder weitere mit jeweils mindestens einem Flachteil gebildete Halbleiterbauelemente aufweist, wobei das Flachteil des dritten oder der weiteren Halbleiterbauelemente jeweils in einer Richtung schräg, insbesondere quer, zu den flächigen Erstreckungsrichtungen des Flachteils des ersten (20) und/oder zweiten (30) Halbleiterbauelements von diesem angeordnet und vorzugsweise mittels des elektrisch leitfähigen Leiterbahnflachteils (80) oder eines oder mehrerer weiterer Leiterbahnflachteile elektrisch angebunden ist/sind.

4. Leistungsmodul nach einem der vorhergehenden Ansprüche, bei welchem zumindest das erste (20) mit zweitem Halbleiterbauelement (30) und/oder drittem und/oder weiteren Halbleiterbauelementen, vorzugsweise zumindest das Flachteil des ersten (20) mit jenem des zweiten und/oder dritten und/oder weiteren Halbleiterbauelements (30), in einer Richtung schräg, insbesondere quer, zu den flächigen Erstreckungsrichtungen des ersten und/oder zweiten Halbleiterbauelements gesehen überlappt.

5. Leistungsmodul nach einem der vorhergehenden Ansprüche, bei welchem das Leiterbahnflachteil (80) mit Metall, insbesondere mit Kupfer, gebildet ist.

6. Leistungsmodul nach einem der vorhergehenden Ansprüche, bei welchem das Leiterbahnflachteil (80) an erstes (20) und/oder zweites Halbleiterbauelement (30), insbesondere jeweils an das Flachteil des ersten und/oder zweiten Halbleiterbauelements, gesintert ist.

7. Leistungsmodul nach einem der vorhergehenden Ansprüche, bei welchem das erste (20) und/oder zweite Halbleiterbauelement (30), insbesondere an einer Flachseite des mindestens einen Flachteils dieses Halbleiterbauelements, an ein Substrat (40, 110), insbesondere ein DCB-Substrat (40, 110), angebunden ist.

8. Leistungsmodul nach einem der vorhergehenden Ansprüche, bei welchem das mindestens eine oder eines der Flachteile des ersten (20) und/oder zweiten Halbleiterbauelementes (30) mindestens die Hälfte, vorzugsweise mehr als 80 Prozent und idealerweise 100 Prozent, des Volumens jeweils dieses Halbleiterbauelements einnimmt.

9. Leistungsmodul nach einem der vorhergehenden Ansprüche, welches mindestens einen Phasenanschluss (125) aufweist, welcher an das mindestens eine Halbleiterbahnflachteil (80) angebunden ist.

10. Vorrichtung, insbesondere Umrichter (200) und/oder Stromversorgungsvorrichtung, mit einem Leistungsmodul (10) nach einem der vorhergehenden Ansprüche.
